# NEUE EUROPÄISCHE PATENTSCHRIFT

(11) **EP 3 375 004 B2**
(45) Veröffentlichungstag und Bekanntmachung des Hinweises auf die Entscheidung über den Einspruch: **28.09.2022**
(45) Hinweis auf die Patenterteilung: 28.08.2019
(21) Anmeldenummer: 16794980.9
(22) Anmeldetag: 07.11.2016
(51) Int. Cl.: H01H 47/00

(54) **VERFAHREN UND VORRICHTUNG ZUR STEUERUNG EINES ELEKTROMAGNETISCHEN ANTRIEBS EINES SCHALTGERÄTS**
METHOD AND DEVICE FOR CONTROLLING AN ELECTROMAGNETIC DRIVE OF A SWITCHING DEVICE
PROCÉDÉ ET DISPOSITIF DE COMMANDE D'UN ENTRAÎNEMENT ÉLECTROMAGNÉTIQUE D'UN COMMUTATEUR

(30) Priorität: 12.11.2015 DE 102015119512
(43) Veröffentlichungstag der Anmeldung: 19.09.2018
(73) Patentinhaber: Eaton Intelligent Power Limited, Dublin 4 (IE)
(72) Erfinder: MEID, Wolfgang, 56218 Mülheim-Kärlich (DE); FRIEDRICHSEN, Lutz, 52353 Düren (DE); SCHAAR, Ingo, 53123 Bonn (DE)
(74) Vertreter: Bucher, Ralf Christian
(86) Internationale Anmeldenummer: PCT/EP2016/076876
(87) Internationale Veröffentlichungsnummer: WO 2017/080963

(56) Entgegenhaltungen:
- EP-A1- 2 830 081
- EP-A1- 2 894 745
- WO-A2-2009/121667
- DE-A1- 19 526 038
- US-A- 4 812 945
- US-A- 5 754 386
- US-A- 5 754 386

## Beschreibung

Die Erfindung betrifft ein Verfahren zur Steuerung eines elektromagnetischen Antriebs eines Schaltgeräts, insbesondere eines Schütz, sowie eine entsprechende Vorrichtung und ein Schaltgerät mit einer derartigen Vorrichtung. Ein Verfahren zur Steuerung eines elektromagnetischen Antriebs eines Schaltgeräts mittels eines Programms ist zum Beispiel vom Dokument US 5 754 386 A bekannt. Weiterhin ist aus der DE 195 26 038 B4 ein Verfahren zur Steuerung eines elektromagnetischen Antriebs eines Schaltgeräts gemäß dem Oberbegriff von Anspruch 1 bekannt.

Schaltgeräte wie beispielsweise Schütze werden mit einer Bemessungssteuerspeisespannung gefertigt. Durch die Normen VDE 0660-100 bzw. IEC/EN/DIN EN 60947-1 sind in Absatz 7.2.1.2 sind Grenzwerte für die Betätigung von Schaltgeräten mit Kraftantrieb vorgegeben.

Beispielsweise ist festgelegt, dass ein Schütz zwischen 85% und 110% seiner Bemessungssteuerspeisespannung einschalten muss. Dies gilt sowohl für Gleich- als auch für Wechselspannung. Sofern für die Bemessungssteuerspeisespannung ein Bereich angegeben wird, beziehen sich die 85% auf den unteren Spannungswert und die 110% auf den oberen Spannungswert.

Ein elektronisch gesteuertes Schütz muss zwischen 75% und 20% bei Wechselspannung bzw. 10% bei Gleichspannung der Bemessungssteuerspeisespannung abfallen, d.h. es kann bei 75% abfallen, muss jedoch bei 20% bzw. 10% abgefallen sein. Bei einem für die Betätigung des Schützes angegebenen Bereich der Bemessungssteuerspeisespannung beziehen sich die 20% bzw. 10% auf den oberen Spannungswert und die 75% auf den unteren Spannungswert des Bereichs.

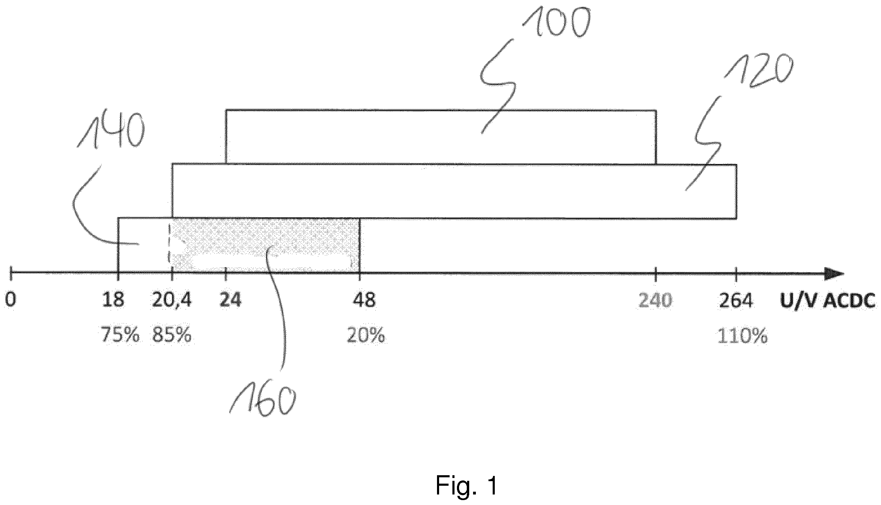

Der Bereich der Bemessungssteuerspeisespannung (hierin auch kurz als Bemessungsspannungsbereich bezeichnet) darf nicht zu groß sein, da ansonsten eine Überschneidung sich ausschließender Spannungsbereiche auftreten könnte, wie es an folgendem Beispiel eines Schützes und unter Bezug auf die in Fig. 1 gezeigten Spannungsbereiche des Schützes erläutert werden soll: bei einem Bemessungsspannungsbereich 100 von 24 Volt bis 240 Volt (Wechsel- oder Gleichspannung) muss das Schütz normgemäß in einem Spannungsbereich 120 von 85% von 24 Volt, also 20,4 Volt, bis 110% von 240 Volt, also 264 Volt einschalten. Laut Norm kann das Schütz bei 75% von 24 Volt, also bei 18 Volt abfallen, muss aber bei 20% von 240 Volt, also bei 48 Volt für Wechselspannung abgefallen sein (Spannungsbereich 140). Wie in Fig. 1 erkennbar ist, überschneiden sich die Ein- und Ausschaltbereiche des Schützes im Spannungsbereich 160 von 20,4 bis 48 Volt, in dem das Schütz nicht eingeschaltet werden kann.

Um die durch die obigen Normen vorgegebenen Grenzwerte einzuhalten und die oben geschilderten Überschneidungen der Spannungsbereich zu vermeiden, muss der durch eine Bemessungssteuerspeisespannung vorgegebene Spannungsbereich eines Schaltgeräts relativ klein gewählt werden, und Hersteller müssen ein recht umfangreiches Sortiment an Schaltgeräten vorhalten, die für verschiedene Bemessungsspannungsbereiche geeignet und ausgelegt sind.

Aufgabe der vorliegenden Erfindung ist es nun, ein verbessertes Verfahren und eine verbesserte Vorrichtung zur Steuerung eines elektromagnetischen Antriebs eines Schaltgeräts, insbesondere eines Schützes, vorzuschlagen.

Diese Aufgabe wird durch die Gegenstände der unabhängigen Ansprüche gelöst. Weitere Ausgestaltungen der Erfindung sind Gegenstand der abhängigen Ansprüche.

Ein der vorliegenden Erfindung zugrunde liegender Gedanke besteht darin, abhängig von der Messung einer eingangsseitig an einem Schaltgerät anliegenden Steuerspannung nicht nur einen elektromagnetischen Antrieb des Schaltgeräts zu aktivieren, sondern auch den Bemessungsspannungsbereich des Schaltgeräts einzustellen. Mit anderen Worten wird also der Bemessungsspannungsbereich entsprechend an die eingangsseitig am Schaltgerät anliegenden Steuerspannung angepasst, so dass bei einem für einen großen Bemessungsspannungsbereich, beispielsweise von etwa 24 Volt bis etwa 240 Volt vorgesehenen Schaltgerät Überschneidungen der Ein- und Ausschaltbereiche bei normgemäßem Einsatz des Schaltgeräts vermieden werden können.

Eine Ausführungsform der Erfindung betrifft nun Verfahren zur Steuerung eines elektromagnetischen Antriebs eines Schaltgeräts mittels eines Programmes, wobei ein durch das Programm konfigurierter Prozessor die folgenden Schritten ausführt: Messen einer eingangsseitig am Schaltgerät anliegenden Steuerspannung; Aktivieren des elektromagnetischen Antriebs abhängig von der gemessenen Steuerspannung; Einstellen des Bemessungsspannungsbereichs abhängig von der gemessenen Steuerspannung. Der zweite und dritte Schritt müssen nicht in der angegeben, sondern können auch in einer anderen Reihenfolge ausgeführt werden. Beispielsweise kann der Schritt des Einstellens des Bemessungsspannungsbereichs abhängig von der gemessenen Steuerspannung vor dem Schritt des Aktivierens des elektromagnetischen Antriebs abhängig von der gemessenen Steuerspannung durchgeführt werden.

Insbesondere kann das Verfahren folgende Schritte aufweisen: Initialisieren des Programms und Deklarieren einer Programmvariablen für eine untere Einschaltspannungsschwelle, Überprüfen, ob die gemessene Steuerspannung die untere Einschaltspannungsschwelle überschreitet, und Aktivieren des elektromagnetischen Antriebs abhängig von der Überprüfung.

Das Einstellen des Bemessungsspannungsbereichs abhängig von der gemessenen Steuerspannung kann folgende Schritte aufweisen: Ermitteln, in welchem von vorgegebenen Spannungsbereichen die gemessene Steuerspannung liegt und Anpassen einer unteren Einschaltspannungsschwelle und einer oberen Abschaltspannungsschwelle abhängig von dem ermittelten vorgegebenen Spannungsbereich.

Das Ermitteln, in welchem von vorgegebenen Spannungsbereichen die gemessene Steuerspannung liegt, kann mehrere auszuführende Schritte aufweisen, von denen jeder für einen der vorgegebenen Spannungsbereiche vorgesehen ist, und das Anpassen der unteren Einschaltspannungsschwelle und einer oberen Abschaltspannungsschwelle kann abhängig von dem ermittelten vorgegebenen Spannungsbereich nach jedem der auszuführenden Schritte durchgeführt werden, und die vorgegebenen Spannungsbereiche können mit jedem ausgeführten Schritt in höhere Spannungsbereiche verschoben werden.

Insbesondere weisen die vorgegebenen Spannungsbereiche keine Überlappungen auf.

Beispielsweise können die vorgegebenen Spannungsbereiche einen ersten vorgegebenen Wechsel- oder Gleich-Spannungsbereich von etwa 24 Volt bis etwa 48 Volt, einen zweiten vorgegebenen Wechsel- oder Gleich-Spannungsbereich von etwa 48 Volt bis etwa 110 Volt und einen dritten vorgegebenen Wechsel- oder Gleich-Spannungsbereich von etwa 110 Volt bis etwa 240 Volt aufweisen.

Das Einstellen des Bemessungsspannungsbereichs abhängig von der gemessenen Steuerspannung kann auch das Berechnen einer unteren Einschaltspannungsschwelle und einer oberen Abschaltspannungsschwelle abhängig von der gemessenen Steuerspannung aufweisen. Beispielsweise kann als untere Einschaltspannungsschwelle 85% der gemessenen Steuerspannung und als obere Abschaltspannungsschwelle 50% von der gemessenen Steuerspannung berechnet werden. Diese Berechnung eines Bemessungsspannungsbereichs kann zusätzlich oder auch alternativ zur oben beschriebenen algorithmischen schrittweisen Ermittlung eines Bemessungsspannungsbereichs durchgeführt werden, beispielsweise möglichst schnell einen Bemessungsspannungsbereich zu ermitteln.

Weiterhin kann das Einstellen des Bemessungsspannungsbereichs abhängig von der gemessenen Steuerspannung das Auslesen eines Bemessungsspannungsbereichs aus einer gespeicherten Tabelle abhängig von der gemessenen Steuerspannung und das Einstellen einer unteren Einschaltspannungsschwelle und einer oberen Abschaltspannungsschwelle abhängig vom ausgelesenen Bemessungsspanungsbereich aufweisen. In der gespeicherten Tabelle können beispielsweise mehrere normgemäße Bemessungsspannungsbereiche gespeichert sein. Die gemessene Steuerspannung bestimmt hierbei den passenden Bemessungsspanungsbereich, der somit abhängig von der gemessenen Steuerspannung aus der Tabelle ausgelesen werden kann und für die Einstellung der unteren Einschaltspannungsschwelle und der oberen Abschaltspannungsschwelle verwendet wird.

Weiterhin kann das Einstellen des Bemessungsspannungsbereichs folgende Schritte aufweisen: Überprüfen, ob ein Bemessungsspannungsbereich voreingestellt ist, und Einstellen des Bemessungsspannungsbereichs auf den voreingestellten Bemessungsspannungsbereich.

Der Bemessungsspannungsbereich wird auf den voreingestellten Bemessungsspannungsbereich eingestellt, wenn ein voreingestellter Bemessungsspannungsbereich vorliegt und die gemessene Steuerspannung einen oder mehrere vorgegebene Schwellwerte über- und / oder unterschreitet.

Ein voreingestellter Bemessungsspannungsbereich kann beispielsweise mittels eines Schalters, insbesondere eines DIP-Schalters, eines Speicherwerts und / oder eines per Datenkommunikation empfangenen Wertes festgelegt werden.

Eine weitere Ausführungsform der Erfindung betrifft ein Computerprogramm mit Programmcode zur Durchführung aller Verfahrensschritte nach der Erfindung und wie vorstehend beschrieben, wenn das Computerprogramm von einem Prozessor ausgeführt wird.

Ferner betrifft eine Ausführungsform der Erfindung einen Datenträger, auf dem der von einem Prozessor ausführbare Programmcode des Computerprogramms nach der Erfindung und wie vorstehend beschrieben gespeichert ist.

Eine weitere Ausführungsform der Erfindung betrifft eine Vorrichtung zur Steuerung eines elektromagnetischen Antriebs eines Schaltgeräts aufweisend einen Prozessor, insbesondere einen Mikroprozessor oder Mikrokontroller, und einen Speicher, in dem ein Programm gespeichert ist, das den Prozessor zum Ausführen eines Verfahrens nach der Erfindung und wie hierin beschrieben konfiguriert.

Eine weitere Ausführungsform der Erfindung betrifft ein Schaltgerät, insbesondere Schütz, mit einem Schaltantrieb, der eine Spule aufweist, und einer Vorrichtung nach der Erfindung und wie hierin beschrieben zum Steuern der Stromversorgung der Spule.

Weitere Vorteile und Anwendungsmöglichkeiten der vorliegenden Erfindung ergeben sich aus der nachfolgenden Beschreibung in Verbindung mit den in den Zeichnungen dargestellten Ausführungsbeispielen.

In der Beschreibung, in den Ansprüchen, in der Zusammenfassung und in den Zeichnungen werden die in der hinten angeführten Liste der Bezugszeichen verwendeten Begriffe und zugeordneten Bezugszeichen verwendet.

Die Zeichnungen zeigen in
- Fig. 1 ein Diagramm mit beispielhaften Spannungsbereichen eines Schützes;
- Fig. 2 ein Blockschaltbild eines ersten Ausführungsbeispiels einer Steuervorrichtung für den elektromagnetischen Antrieb eines Schaltgeräts gemäß der vorliegenden Erfindung;
- Fig. 3 ein Blockschaltbild eines zweiten Ausführungsbeispiels einer Steuervorrichtung für den elektromagnetischen Antrieb eines Schaltgeräts gemäß der vorliegenden Erfindung;
- Fig. 4 ein Ablaufdiagramm eines ersten Ausführungsbeispiels eines Steuerverfahrens für einen elektromagnetischen Antrieb eines Schaltgeräts gemäß der vorliegenden Erfindung;
- Fig. 5 ein Ablaufdiagramm eines zweiten Ausführungsbeispiels eines Steuerverfahrens für einen elektromagnetischen Antrieb eines Schaltgeräts gemäß der vorliegenden Erfindung; und
- Fig. 6 ein Ablaufdiagramm eines dritten Ausführungsbeispiels eines Steuerverfahrens für einen elektromagnetischen Antrieb eines Schaltgeräts gemäß der vorliegenden Erfindung.

In der folgenden Beschreibung können gleiche, funktional gleiche und funktional zusammenhängende Elemente mit den gleichen Bezugszeichen versehen sein. Absolute Werte sind im Folgenden nur beispielhaft angegeben und sind nicht als die Erfindung einschränkend zu verstehen.

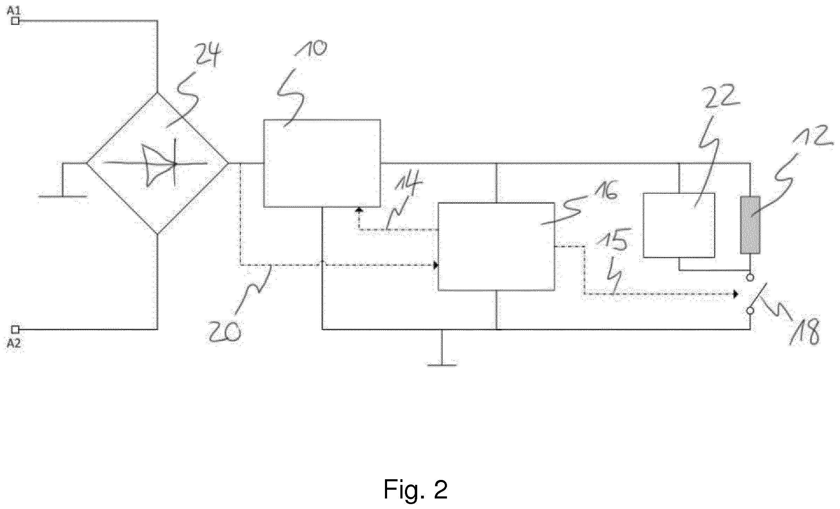

Fig. 2 zeigt ein Blockschaltbild einer Steuervorrichtung bzw. Steuerelektronik gemäß der Erfindung, die prinzipiell für einen weiten Eingangsspannungsbereich ausgelegt und relativ kompakt auf einer Platine implementiert werden kann. Die Steuervorrichtung ist beispielsweise zur Integration in ein Schaltgerät wie ein Schütz geeignet, beispielsweise ein Multispannungs-Schütz. Unter einem Multispannungs-Schütz oder -Schaltgerät wird hierin ein Schütz bzw. Schaltgerät verstanden, das für mehrere unterschiedliche Bemessungsspannungsbereiche vorgesehen und ausgelegt ist, beispielsweise für einen Spannungsbereich von etwa 24 Volt bis etwa 240 Volt.

Die Steuervorrichtung umfasst ein Netzteil 10, eine Steuereinheit 16, beispielsweise implementiert durch einen Prozessor und einen Speicher (insbesondere einen Mikrokontroller), eine Schnellentregungseinheit 22 und einen steuerbaren Schalter 18. Der in Fig. 1 dargestellte Gleichrichter 24 gehört streng genommen nicht zur Steuervorrichtung, kann aber dennoch auf einer Platine der Steuervorrichtung vorgesehen sein. Alle Spannungen und Signale der Steuervorrichtung sind auf Masse bezogen.

Der Gleichrichter 24 wird über eine an den Anschlüssen A1 und A2 anliegende Wechselspannung gespeist. Die vom Gleichrichter 24 aus der Wechselspannung erzeugte Gleichspannung speist das Netzteil 10, welches daraus eine Ausgangsspannung zum Versorgen der Steuereinheit 16 und einer Spule 12 eines elektromagnetischen Antriebs eines (nicht dargestellten) Schaltgeräts generiert. Parallel zur Spule 12 ist die Schnellentregungseinheit 22 geschaltet. Zwischen die Spule 12 und die Masse ist der steuerbare Schalter 18 geschaltet, beispielsweise ein Schalttransistor mit entsprechender Stromtragfähigkeit und Eignung für die auftretenden Spannungen.

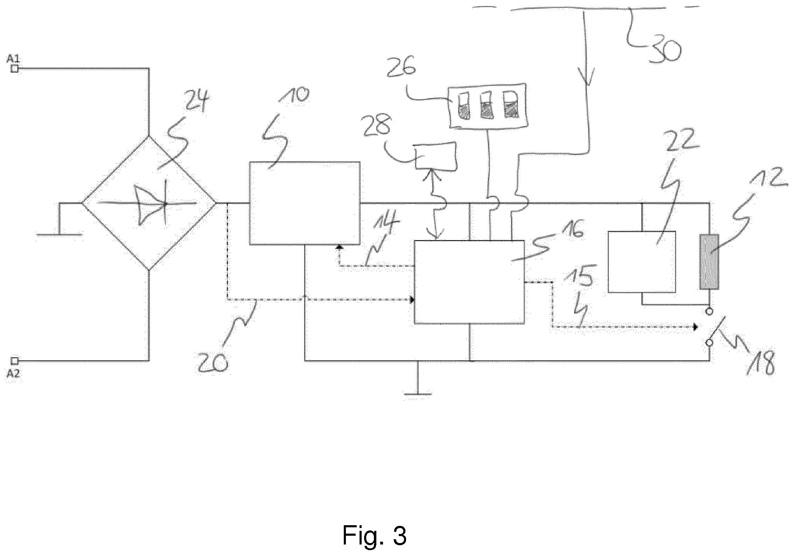

Fig. 3 zeigt ein Blockschaltbild einer weiteren Steuervorrichtung bzw. Steuerelektronik gemäß der Erfindung, bei dem im Unterschied zur in Fig. 2 gezeigten Steuerelektronik ein voreingestellter Bemessungsspannungsbereich auf verschiedene Arten vorgegeben werden kann: beispielsweise kann ein DIP (Dual in-line package)-Schalter 26 auf der Platine der Steuerelektronik angebracht sein, über den sich verschiedene voreingestellte Bemessungsspannungsbereiche kodieren lassen. Es kann auch ein Speicher 28 vorhanden sein, beispielsweise auf der Platine oder integriert in die Steuereinheit 16, in dem ein Speicherwert einen voreingestellten Bemessungsspannungsbereich bestimmen kann. Der Speicher 28 kann wie in Fig. 3 gezeigt von der Steuereinheit 16 ausgelesen und beschrieben werden, insbesondere mit einem von einer externen Quelle empfangenen voreingestellten Bemessungsspannungsbereich. Schließlich ist in Fig. 3 noch als Quelle für einen voreingestellten Bemessungsspannungsbereich ein Datenbus 30 gezeigt, mit dem eine Datenschnittstelle der Steuerelektronik, insbesondere der Steuereinheit 16 datenmäßig verbunden sein kann und über den die Steuerelektronik, insbesondere die Steuereinheit 16 einen Wert empfangen kann, welcher einen voreingestellten Bemessungsspannungsbereich vorgibt.

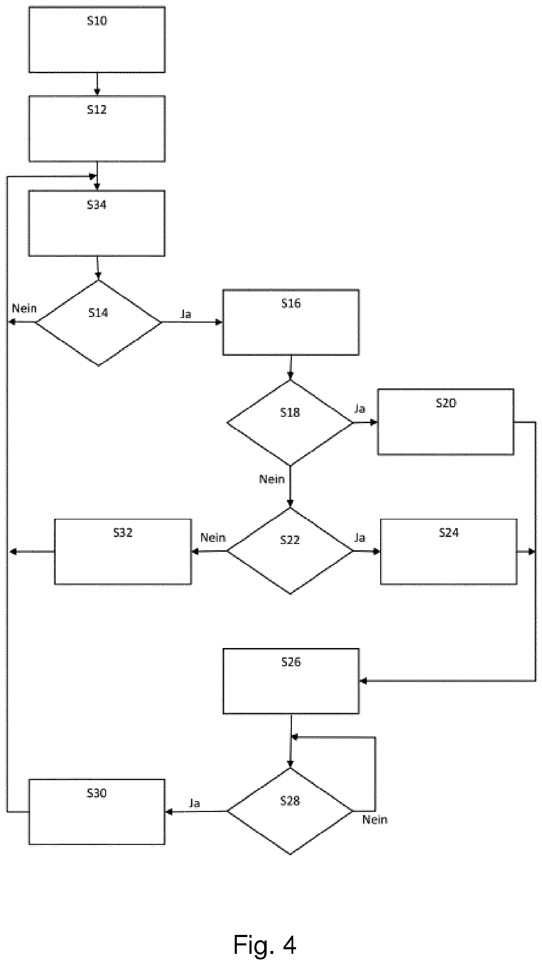

Die Funktionsweise der Steuervorrichtung wird nun anhand des in Fig. 4 gezeigten Ablaufdiagramms eines ersten Ausführungsbeispiels des erfindungsgemäßen Verfahrens erläutert, das beispielsweise durch eine Firmware der Steuervorrichtung implementiert sein kann, die von der Steuereinheit 16, insbesondere einem die Steuereinheit implementierenden Mikrokontroller ausgeführt wird.

Zunächst wird im Schritt S10 dem Schütz die Versorgungsspannung an den Anschlüssen A1 und A2 zugeschaltet und durch den Gleichrichter 24 gleichgerichtet (wenn die zugeschaltete Versorgungsspannung eine Wechselspannung ist). Die Ausgangsspannung des Gleichrichters 24 wird dem Netzteil 10 zugeführt, welches daraus eine Versorgungsspannung für die Steuereinheit 16 generiert, welche dadurch das in ihrem Speicher abgelegte Programm startet.

Mit dem Programmstart wird im Schritt S12 die vom Prozessor der Steuereinheit 16 auszuführende Software initialisiert und alle notwendigen Programm-Variablen werden deklariert, insbesondere werden eine Variable "UntereEinschaltspannung" für eine unterer Einschaltspannungsschwelle und eine Variable "Abschaltspannung" für eine obere Abschaltspannungsschwelle deklariert und auf Initialwerte von beispielsweise etwa 20 Volt (UntereEinschaltspannung(1), z.B. 85% Ucmin ) bzw. etwa 12 Volt (Abschaltspannung(1), z.B. 50% Ucmin) gesetzt.

Die Steuereinheit 16 misst nach Schritt S12 in einem Schritt S34 die ihr eingangsseitig zugeführte Ausgangsspannung 20 des Gleichrichters 24 und wertet diese Messspannung "Umess" im Schritt S14 aus, indem sie überprüft, ob die Messspannung die untere Einschaltspannungsschwelle "UntereEinschaltspannung(1)" überschreitet. Ist dies nicht der Fall, werden die Schritte S34 und S14 so lange wiederholt bis die Schwelle "UntereEinschaltspannung(1)" überschritten ist.

Überschreitet die Messspannung die untere Einschaltspannungsschwelle, aktiviert die Steuereinheit 16 im darauffolgenden Schritt S16 den elektromagnetischen Antrieb des Schaltgeräts, indem sie über ein Steuersignal 14 dem Netzteil 10 signalisiert, eine Anzugspannung zur Speisung der Spule 12 zu erzeugen und über ein zweites Steuersignal 15 den steuerbaren Schalter 18 zu schließen, so dass Strom durch die Spule 12 fließen kann.

Nach dem Aktivieren des Antriebs im Schritt S16 fährt die Steuereinheit 16 mit der Einstellung des Bemessungsspannungsbereiches des Schaltgeräts abhängig von der an den Anschlüssen A1 und A2 anliegenden Steuerspannung des Schaltgeräts in den darauffolgenden Programmschritten S18 bis S22 (S22 steht für den (n)ten Spannungsbereich) fort.

Hierzu wird in einem Schritt S18 zunächst überprüft, ob die Messspannung "Umess" in einem ersten, insbesondere unteren Spannungsbereich MinBereich(1) bis MaxBereich(1) beispielsweise von etwa 24 Volt bis etwa 48 Volt liegt. Ist dies der Fall, werden in einem Schritt S20 die Variablen "UntereEinschaltspannung" für die untere Einschaltspannungsschwelle und "Abschaltspannung" für die obere Abschaltspannungsschwelle an den ersten Spannungsbereich angepasst. Ist dagegen die Messspannung "Umess" größer als der erste Spannungsbereich, wird auf den nächsten, beispielsweise den nächstgrößeren Spannungsbereich umgeschaltet und überprüft, ob die Messspannung "Umess" in diesem nächstgrößeren Spannungsbereich n liegt und, falls die Messspannung in diesem größeren Spannungsbereich n liegt, die untere Einschaltspannungsschwelle und obere Abschaltspannungsschwelle in einem Schritt S24 entsprechend angepasst. Somit wird überprüft, in welchem der vorgegebenen Spannungsbereiche des Schützes die Messspannung "Umess" liegt und der Bemessungsspannungsbereich des Schützes auf den entsprechenden vorgegebenen Spannungsbereich insbesondere unter Berücksichtigung etwaiger Normvorgaben eingestellt. Im Ablaufdiagramm ist diese Schrittabfolge zum Ermitteln und Einstellen eines geeigneten Bemessungsspannungsbereichs des Schützes abhängig von der Messspannung durch die Schritte S18 und S24 gezeigt. Entsprechend der Anzahl der vorgegebenen Spannungsbereiche sind also Schritte S18, S20 bzw. S22, S24 vorgesehen. Sind beispielsweise drei Spannungsbereiche von etwa 24 Volt bis etwa 48 Volt, von etwa 48 Volt bis etwa 110 Volt und von etwa 110 Volt bis etwa 240 Volt vorgegeben, wären in dem Ablaufdiagramm drei Schrittfolgen S18, S20 bzw. S22, S24 vorgesehen, um festzustellen, welcher der drei Spannungsbereiche, die sich im angegebenen Beispiel idealerweise nicht überschneiden, geeignet wäre. Sollte kein Bemessungsspannungsbereich ermittelbar sein, wird mittels Schritt S32 eine Fehlerroutine verzweigt, in der beispielsweise ein vorgegebener Standard-Bemessungsspannungsbereich eingestellt, eine Fehlermeldung ausgegeben und / oder eine Sicherheits-Abschaltung des Schützes vorgenommen werden kann.

Nach Durchlaufen der vorstehend beschriebenen Schrittabfolge wird der elektromagnetische Antrieb des Schützes im Schritt S26 in einen Haltebetrieb geschaltet, wenn die entsprechenden Bedingungen hierfür erfüllt sind. Die Umschaltung in den Haltebetrieb erfolgt hierbei durch die Steuereinheit 16, die das Steuersignal 14 so einstellt, dass das Netzteil 10 eine für den Haltebetrieb geeignete und vorgesehene Spannung als Haltespannung zum Speisen der Spule 12 erzeugt.

Nach dem Umschalten in den Haltebetrieb des Schützes wird im Schritt S28 von der Steuereinheit 16 fortlaufend die Messspannung "Umess" auf ein Unterschreiten der oberen Abschaltspannungsschwelle des in den Schritten S18-S24 eingestellten Bemessungsspannungsbereichs überprüft. Sobald die obere Abschaltspannungsschwelle unterschritten wird, schaltet die Steuereinheit 16 den Schaltantrieb im Schritt S30 ab, indem sie das zweite Steuersignal 15 so erzeugt und ausgibt, dass der steuerbare Schalter 18 geöffnet wird. Nach dem Öffnen des Schalters 18 wird automatisch die Schnellentregung 22 aktiv, über welche die in der Spule 12 gespeicherte Energie entladen wird.

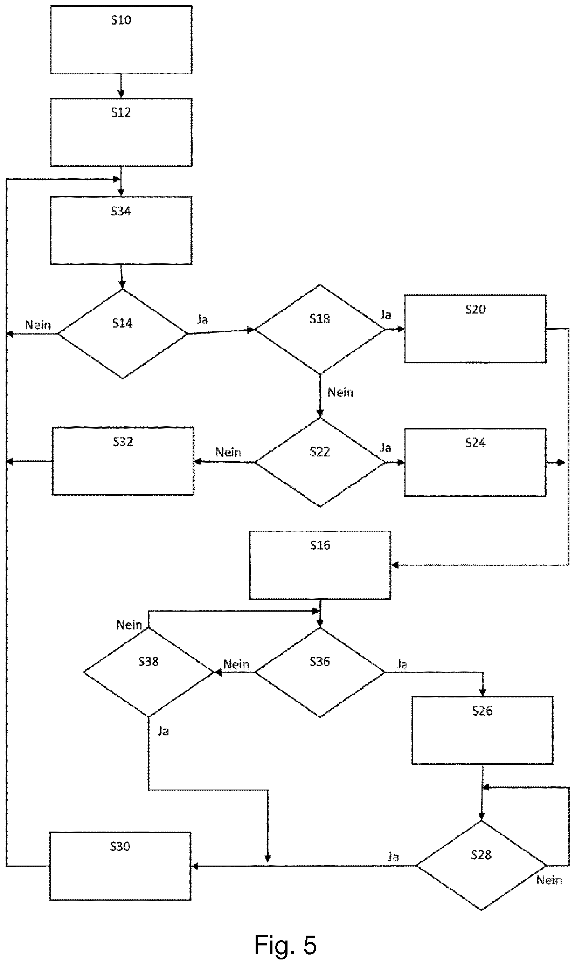

Eine etwas andere Funktionsweise der Steuervorrichtung wird nun anhand des in Fig. 5 gezeigten Ablaufdiagramms eines zweiten Ausführungsbeispiels des erfindungsgemäßen Verfahrens erläutert. Im Ablaufdiagramm werden für Schritte, die ähnlich oder identisch zu Schritten des Ablaufdiagramms von Fig. 4 sind, die gleichen Bezugszeichen verwendet. Das in Fig. 5 gezeigte Ablaufdiagramm unterscheidet sich von dem in Fig. 4 gezeigten Ablaufdiagramm vor allem darin, dass zunächst ein geeigneter Bemessungsspannungsbereich des Schützes ermittelt und erst danach der Schützantrieb aktiviert wird.

Die Schritte S10, S12, S34 und S14 und ihr Ablauf entsprechen den Schritten und der entsprechenden Abfolge des Ablaufdiagramms von Fig. 4.

Sobald Umess in S14 die Schwelle "UntereEinschaltspannung(1)" überschritten hat, wird in den darauffolgenden Programmschritten S18 bis S22 (S22 steht für den (n)ten Spannungsbereich) der für die gemessene Eingangsspannung relevante Bemessungsspannungsbereich wie beim Ablaufdiagramm von Fig. 4 ermittelt.

Nach erfolgreicher Bemessungsspannungsbereich-Zuordnung aktiviert die Steuereinheit 16 im darauffolgenden Schritt S16 den elektromagnetischen Antrieb des Schaltgeräts, indem sie über ein Steuersignal 14 dem Netzteil 10 signalisiert, eine Anzugspannung zur Speisung der Spule 12 zu erzeugen und über ein zweites Steuersignal 15 den steuerbaren Schalter 18 schließt, so dass Strom durch die Spule 12 fließen kann.

Nach der Aktivierung des Antriebes wird in Schritt S36 überprüft, ob der Anzugsvorgang abgeschlossen werden kann. Gleichzeitig wird in Schritt S38 die Abschaltbedingung für das Schütz überwacht, nämlich ob die Messspannung "Umess" die obere Abschaltspannungsschwelle des S24 eingestellten Bemessungsspannungsbereichs unterschreitet. Nach Durchlaufen der vorstehend beschriebenen Schrittabfolge wird der elektromagnetische Antrieb des Schützes im Schritt S26 in einen Haltebetrieb geschaltet. Die Umschaltung in den Haltebetrieb erfolgt hierbei durch die Steuereinheit 16, die das Steuersignal 14 so einstellt, dass das Netzteil 10 eine für den Haltebetrieb geeignete und vorgesehene Spannung als Haltespannung zum Speisen der Spule 12 erzeugt.

Nach dem Umschalten in den Haltebetrieb des Schützes wird im Schritt S28 von der Steuereinheit 16 fortlaufend die Messspannug "Umess" auf ein Unterschreiten der oberen Abschaltspannungsschwelle des in den Schritten S18-S24 eingestellten Bemessungsspannungsbereichs überprüft. Sobald die obere Abschaltspannungsschwelle unterschritten wird, schaltet die Steuereinheit 16 den Schaltantrieb ab, indem sie das zweite Steuersignal 15 so erzeugt und ausgibt, dass der steuerbare Schalter 18 geöffnet wird. Nach dem Öffnen des Schalters 18 wird automatisch die Schnellentregung 22 aktiv, über welche die in der Spule 12 gespeicherte Energie entladen wird.

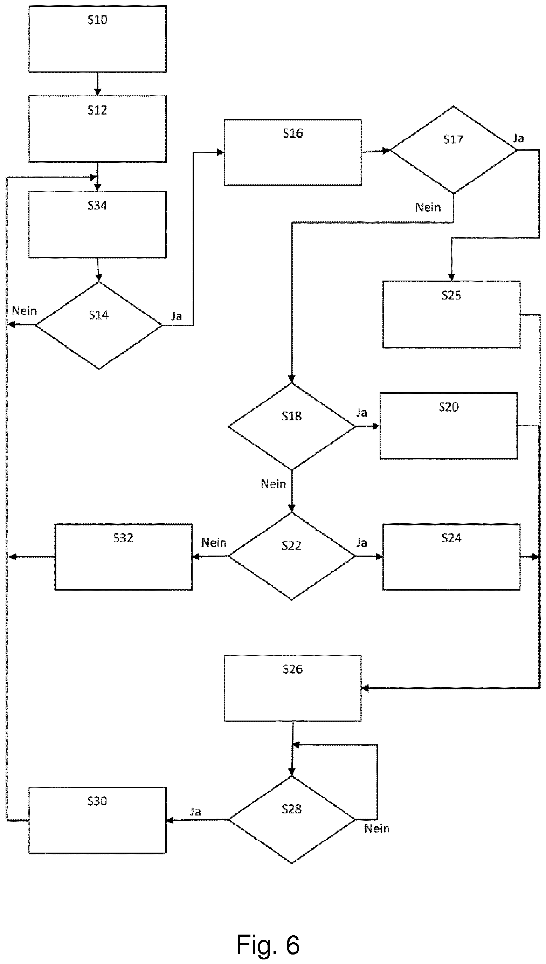

Fig. 6 zeigt schließlich ein Ablaufdiagramm mit einer Funktionsweise der Steuervorrichtung mit Berücksichtigung eines voreingestellten Bemessungsspannungsbereichs, der wie bei der in Fig. 3 gezeigten Schaltung aus verschiedenen Quellen wie einem DIP-Schalter 26, einem Speicher 28 oder von einer externen Quelle, die über einen Datenbus 30 mit der Schaltung verbunden ist, stammen kann. Das Ablaufdiagramm von Fig. 6 unterscheidet sich von dem von Fig. 4 im Einstellen des Bemessungsspanungsbereichs: nach dem Aktivieren des Antriebs im Schritt S16 überprüft die Steuereinheit 16 zunächst in einem Schritt S17, ob ein Bemessungsspannungsbereich voreingestellt ist, also ob beispielsweise bei der in Fig. 3 gezeigten Schaltung über den DIP-Schalter 26 ein voreingestellter Bemessungsspannungsbereich kodiert ist, ob im Speicher 28 ein Speicherwert abgelegt ist, der einen voreingestellten Bemessungsspannungsbereich definiert, und / oder ob über den Datenbus 30 ein Wert empfangen wird oder wurde (der beispielsweise im Speicher 28 oder einem Zwischenspeicher der Steuereinheit 16 abgelegt wurde). Ergibt die Prüfung im Schritt S17, dass ein voreingestellter Bemessungsspannungsbereich vorhanden ist, wird der Bemessungsspannungsbereich durch die Steuereinheit 16 auf den voreingestellten Bemessungsspannungsbereich im Schritt S25 eingestellt. Ergibt die Prüfung im Schritt S17 dagegen, dass kein voreingestellter Bemessungsspannungsbereich vorhanden ist, wird mit der Einstellung des Bemessungsspannungsbereiches wie oben in Bezug auf das in Fig. 4 gezeigte Ablaufdiagramm fortgefahren. Der Schritt S17 kann auch derart implementiert sein, dass als Kriterium für die Einstellung des Bemessungsspannungsbereichs auf einen voreingestellten Bemessungsspannungsbereich nicht alleine das Vorliegen eines voreingestellten Bemessungsspannungsbereich als beispielsweise per Schalter kodierter Wert oder als Speicherwert zählt, sondern auch noch, wie stabil die die Versorgungsspannung an den Anschlüssen A1 und A2 ist. Die Stabilität kann insbesondere anhand von vorgegebenen Schwellwerten wie Mindest- und Maximalspannungswerten ermittelt werden: über- und / oder unterschreitet die die Versorgungsspannung an den Anschlüssen A1 und A2 diese Schwellwerte, kann daraus auf eine eher instabile Versorgungsspannung an den Anschlüssen A1 und A2 geschlossen und im Schritt S17 bestimmt werden, dass der voreingestellte Bemessungsspannungsbereich anstelle eine automatisch abhängig von der Versorgungsspannung an den Anschlüssen A1 und A2 ermittelten Bemessungsspannungsbereich verwendet wird. Hierdurch kann die Betriebssicherheit einer erfindungsgemäßen Schaltvorrichtung weiter erhöht werden, vor allem in einer Betriebsumgebung mit einer stark schwankenden oder einbrechenden Versorgungsspannung an den Anschlüssen A1 und A2.

Der wesentliche Vorteil der vorliegenden Erfindung besteht in der Möglichkeit der Implementierung eines Multispannungs-Schaltgeräts, das für einen großen Eingangsspannungsbereich geeignet ist. Dadurch ergeben sich weitere nachfolgende Vorteile: die Spulentypen des elektromagnetischen Antriebs können reduziert werden, da nicht mehr für jeden Eingangsspannungsbereich eine eigene Spule verwendet muss, sondern eine Spule für mehrere Eingangsspannungsvarianten verwendet werden kann; die Anzahl der Bauteile kann reduziert werden; es wird ein universell einsetzbares "Plug and Play"-Schaltgerät geschaffen, das in vielen Installation eingesetzt werden kann, ohne Einschränkungen aufgrund einer bestimmten Steuerspannung.

## Patentansprüche

1. Verfahren zur Steuerung eines elektromagnetischen Antriebs eines Schaltgeräts mittels eines Programmes, wobei ein durch das Programm konfigurierter Prozessor die folgenden Schritte ausführt:
Messen einer eingangsseitig am Schaltgerät anliegenden Steuerspannung (S12);
Aktivieren des elektromagnetischen Antriebs abhängig von der gemessenen Steuerspannung (S14-S16; S14, S34);
und
Einstellen eines Bemessungsspannungsbereichs abhängig von der gemessenen Steuerspannung (S18-S24),
**dadurch gekennzeichnet, dass** das Einstellen des Bemessungsspannungsbereichs ferner folgende Schritte aufweist:
Überprüfen, ob ein Bemessungsspannungsbereich voreingestellt ist (S17), und
Einstellen des Bemessungsspannungsbereichs auf den voreingestellten Bemessungsspannungsbereich (S25), wenn ein voreingestellter Bemessungsspannungsbereich vorliegt und die gemessene Steuerspannung einen oder mehrere vorgegebene Schwellwerte über- und / oder unterschreitet.

2. Verfahren nach Anspruch 1, **dadurch gekennzeichnet, dass** es folgende Schritte aufweist:
Initialisieren des Programms und Deklarieren einer Programmvariablen für eine untere Einschaltspannungsschwelle (S12),
Überprüfen, ob die gemessene Steuerspannung die untere Einschaltspannungsschwelle überschreitet (S14), und
Aktivieren des elektromagnetischen Antriebs abhängig von der Überprüfung (S16; S34).

3. Verfahren nach Anspruch 1 oder 2, **dadurch gekennzeichnet, dass** das Einstellen des Bemessungsspannungsbereichs abhängig von der gemessenen Steuerspannung folgende Schritte aufweist:
Ermitteln, in welchem von vorgegebenen Spannungsbereichen die gemessene Steuerspannung liegt (S18, S22) und
Anpassen einer unteren Einschaltspannungsschwelle und einer oberen Abschaltspannungsschwelle abhängig von dem ermittelten vorgegebenen Spannungsbereich (S20, S24).

4. Verfahren nach Anspruch 3, **dadurch gekennzeichnet, dass** das Ermitteln, in welchem von vorgegebenen Spannungsbereichen die gemessene Steuerspannung liegt, mehrere auszuführende Schritte (S18, S22) aufweist, von denen jeder für einen der vorgegebenen Spannungsbereiche vorgesehen ist, und das Anpassen der unteren Einschaltspannungsschwelle und einer oberen Abschaltspannungsschwelle abhängig von dem ermittelten vorgegebenen Spannungsbereich (S20, S24) nach jedem der auszuführenden Schritte (S18, S22) durchgeführt wird, und die vorgegebenen Spannungsbereiche mit jedem ausgeführten Schritt in höhere Spannungsbereiche verschoben werden.

5. Verfahren nach Anspruch 3 oder 4, **dadurch gekennzeichnet, dass** die vorgegebenen Spannungsbereiche keine Überlappungen aufweisen.

6. Verfahren nach Anspruch 3, 4 oder 5,**dadurch gekennzeichnet, dass** die vorgegebenen Spannungsbereiche einen ersten vorgegebenen Wechsel- oder Gleich-Spannungsbereich von etwa 24 Volt bis etwa 48 Volt, einen zweiten vorgegebenen Wechsel- oder Gleich-Spannungsbereich von etwa 48 Volt bis etwa 110 Volt und einen dritten vorgegebenen Wechsel- oder Gleich-Spannungsbereich von etwa 110 Volt bis etwa 240 Volt aufweisen.

7. Verfahren nach einem der vorhergehenden Ansprüche, **dadurch gekennzeichnet, dass** das Einstellen des Bemessungsspannungsbereichs abhängig von der gemessenen Steuerspannung das Berechnen einer unteren Einschaltspannungsschwelle und einer oberen Abschaltspannungsschwelle abhängig von der gemessenen Steuerspannung aufweist.

8. Verfahren nach einem der vorhergehenden Ansprüche, **dadurch gekennzeichnet, dass** das Einstellen des Bemessungsspannungsbereichs abhängig von der gemessenen Steuerspannung das Auslesen eines Bemessungsspannungsbereichs aus einer gespeicherten Tabelle abhängig von der gemessenen Steuerspannung und das Einstellen einer unteren Einschaltspannungsschwelle und einer oberen Abschaltspannungsschwelle abhängig vom ausgelesenen Bemessungsspanungsbereich aufweist.

9. Verfahren nach einem der vorhergehenden Ansprüche, **dadurch gekennzeichnet, dass** ein voreingestellter Bemessungsspannungsbereich mittels eines Schalters, insbesondere eines DIP-Schalters (26), eines Speicherwerts (28) und / oder eines per Datenkommunikation (30) empfangenen Wertes festgelegt wird.

10. Computerprogramm mit Programmcode zur Durchführung der Verfahrensschritte nach einem der vorhergehenden Ansprüche, wenn das Computerprogramm von einem Prozessor ausgeführt wird.

11. Datenträger, auf dem der von einem Prozessor ausführbare Programmcode des Computerprogramms nach Anspruch 10 gespeichert ist.

12. Vorrichtung zur Steuerung eines elektromagnetischen Antriebs eines Schaltgeräts aufweisend einen Prozessor (16) und einen Speicher, in dem ein Programm gespeichert ist, das den Prozessor zum Ausführen eines Verfahrens nach einem der Ansprüche 1 bis 9 konfiguriert.

13. Schaltgerät, insbesondere Schütz, mit
- einem Schaltantrieb, der eine Spule (12) aufweist, und
- einer Vorrichtung (16) nach Anspruch 12 zum Steuern der Stromversorgung der Spule (12).

## Claims

1. Method for controlling an electromagnetic drive of a switching device by means of a program, wherein a processor configured by the program carries out the following steps:
Measuring a control voltage applied to the switching device on the input side (S12);
Activating the electromagnetic drive in response to the measured control voltage (S14-S16, S14, S34);
and
Setting a rated voltage range depending on the measured control voltage (S18-S24),
**characterized in that**
the setting of the rated voltage range further comprises the following steps:
checking if a rated voltage range is pre-set (S17), and
setting the rated voltage range to the pre-set rated voltage range (S25) if a pre-set rated voltage range exists and the measured control voltage exceeds and/or falls below one or more specified threshold values.

2. Method according to claim 1,
**characterised in that**
the method comprises the following steps:
initialising the program and declaring a program variable for a lower turn-on voltage threshold (S12),
checking that the measured control voltage exceeds the lower turn-on voltage threshold (S14), and
activating the electromagnetic drive depending on the check (S16; S34).

3. Method according to claim 1 or 2,
**characterised in that**
the setting of the rated voltage range depending on the measured control voltage comprises the following steps:
determining in which of the specified voltage ranges the measured control voltage lies (S18, S22) and
adjusting a lower turn-on voltage threshold and an upper turn-off voltage threshold depending on the determined specified voltage range (S20, S24).

4. Method according to claim 3,
**characterised in that**
the process of determining in which of the specified voltage ranges the measured control voltage lies has a plurality of steps to be executed (S18, S22), each of which is provided for one of the specified voltage ranges, and the process of adjusting the lower turn-on voltage threshold and an upper turn-off voltage threshold depending on the determined specified voltage range (S20, S24) is performed after each of the steps to be executed (S18, S22), and the prescribed voltage ranges are shifted to higher voltage ranges with each executed step.

5. Method according to claim 3 or 4,
**characterised in that**
the specified voltage ranges have no overlaps.

6. Method according to claim 3, 4 or 5,
**characterised in that**
the specified voltage ranges have a first specified AC or DC voltage range of approx. 24 volts to approx. 48 volts, a second specified AC or DC voltage range of approx. 48 volts to approx. 110 volts and a third specified AC or DC voltage range of approx. 110 volts to approx. 240 volts.

7. Method according to any one of the preceding claims,
**characterised in that**
the setting of the rated voltage range depending on the measured control voltage comprises calculating a lower turn-on voltage threshold and an upper turn-off voltage threshold depending on the measured control voltage.

8. Method according to any one of the preceding claims,
**characterised in that**
the setting of the rated voltage range depending on the measured control voltage comprises reading off a rated voltage range from a stored table depending on the measured control voltage and setting a lower turn-on voltage threshold and an upper turn-off voltage threshold depending on the rated voltage range read off.

9. Method according to any one of the preceding claims,
**characterised in that**
a pre-set rated voltage range is determined by means of a switch, in particular a DIP switch (26), a stored value (28) and/or a value received via data communication (30).

10. Computer program with program code for performing the method steps according to any one of the preceding claims, when the computer program is executed by a processor.

11. Data carrier on which the processor-executable program code of the computer program according to claim 10 is stored.

12. Device for controlling an electromagnetic drive of a switching device comprising a processor (16) and a memory in which a program is stored, which configures the processor for carrying out a method according to any one of claims 1 to 9.

13. Switching device, in particular contactor, having
- a switching drive which has a solenoid (12), and
- a device (16) according to claim 12 for controlling the power supply to the solenoid (12).

## Revendications

1. Procédé servant à commander un entraînement électromagnétique d'un appareil de commutation au moyen d'un programme, dans lequel un processeur configuré par le programme exécute les étapes suivantes :
de mesure d'une tension de commande appliquée côté entrée au niveau de l'appareil de commutation (S12) ;
d'activation de l'entraînement électromagnétique en fonction de la tension de commande mesurée (S14-S16 ; S14, S34) ;
et de réglage d'une plage de tensions de mesure en fonction de la tension de commande mesurée (S18-S24),
**caractérisé en ce que**
le réglage de la plage de tensions de mesure présente en outre des étapes suivantes:
de vérification si une plage de tensions de mesure est préréglée (S17), et
de réglage de la plage de tensions de mesure sur la plage de tensions de mesure préréglée (S25),quand une plage de tensions de mesure préréglée est présente et que la tension de commande mesurée passe au-dessus et/ou au-dessous d'une ou plusieurs valeurs de seuil spécifiées.

2. Procédé selon la revendication 1,
**caractérisé en ce que**
il présente des étapes suivantes :
d'initialisation du programme et de déclaration d'une variable de programme pour un seuil de tension de mise en service inférieur (S12),
de vérification si la tension de commande mesurée dépasse le seuil de tension de mise en service inférieur (S14), et
d'activation de l'entraînement électromagnétique en fonction de la vérification (S16 ; S34).

3. Procédé selon la revendication 1 ou 2,
**caractérisé en ce que**
le réglage de la plage de tensions de mesure présente en fonction de la tension de commande mesurée des étapes suivantes :
de détermination parmi des plages de tensions spécifiées de celle, dans laquelle la tension de commande mesurée se situe (S18, S22), et
d'adaptation d'un seuil de tension de mise en service inférieur et d'un seuil de tension de mise hors service supérieur en fonction de la plage de tensions spécifiée déterminée (S20, S24).

4. Procédé selon la revendication 3,
**caractérisé en ce que**
la détermination parmi des plages de tensions spécifiées de celle, dans laquelle la tension de commande mesurée se situe, présente plusieurs étapes (S18, S22) à exécuter, dont chacune est prévue pour une des plages de tensions spécifiées, et l'adaptation du seuil de tension de mise en service inférieur et d'un seuil de tension de mise hors service supérieur en fonction de la plage de tensions spécifiée déterminée (S20, S24) est mise en oeuvre après chacune des étapes (S18, S22) à exécuter et les plages de tensions spécifiées sont décalées avec chaque étape exécutée dans des plages de tensions plus élevées.

5. Procédé selon la revendication 3 ou 4,
**caractérisé en ce que**
les plages de tensions spécifiées ne présentent aucun chevauchement.

6. Procédé selon la revendication 3, 4 ou 5,
**caractérisé en ce que**
les plages de tensions spécifiées présentent une première plage de tensions alternatives ou continues spécifiée allant d'environ 24 volts à environ 48 volts, une deuxième plage de tensions alternatives ou continues spécifiée allant d'environ 48 volts à environ 110 volts et une troisième plage de tensions alternatives ou continues spécifiée allant d'environ 110 volts à environ 240 volts.

7. Procédé selon l'une quelconque des revendications précédentes,
**caractérisé en ce que**
le réglage de la plage de tensions de mesure en fonction de la tension de commande mesurée présente le calcul d'un seuil de tension de mise en service inférieur et d'un seuil de tension de mise hors service supérieur en fonction de la tension de commande mesurée.

8. Procédé selon l'une quelconque des revendications précédentes,
**caractérisé en ce que**
le réglage de la plage de tensions de mesure en fonction de la tension de commande mesurée présente la lecture d'une plage de tensions de mesure depuis un tableau mémorisé en fonction de la tension de commande mesurée et le réglage d'un seuil de tension de mise en service inférieur et d'un seuil de tension de mise hors service supérieur en fonction de la plage de tensions de mesure lue.

9. Procédé selon l'une quelconque des revendications précédentes,
**caractérisé en ce que**
une plage de tensions de mesure préréglée est fixée au moyen d'un commutateur, en particulier d'un commutateur DIP (26), d'une valeur en mémoire (28) et/ou d'une valeur reçue par communication de données (30).

10. Programme informatique avec un code de programme servant à mettre en oeuvre les étapes de procédé selon l'une quelconque des revendications précédentes, quand le programme informatique est exécuté par un processeur.

11. Support de données, sur lequel le code de programme, pouvant être exécuté par un processeur, du programme informatique selon la revendication 10 est mémorisé.

12. Dispositif servant à commander un entraînement électromagnétique d'un appareil de commutation présentant un processeur (16) et une mémoire, dans laquelle un programme est mémorisé, qui configure le processeur pour exécuter un procédé selon l'une quelconque des revendications 1 à 9.

13. Appareil de commutation, en particulier contacteur, avec
- un entraînement de commutation, qui présente une bobine (12), et
- un dispositif (16) selon la revendication 12 servant à commander l'alimentation en courant de la bobine (12).
